# EUROPEAN PATENT SPECIFICATION

(11) **EP 4 628 914 B1**
(45) Date of publication and mention of the grant of the patent: **02.12.2026**
(21) Application number: 23907635.9
(22) Date of filing: 15.12.2023
(51) Int. Cl.: G01R 31/367, G01R 31/392, G01R 31/378, G01R 31/3828, H01M 10/48, H01M 10/42

(54) **DIAGNOSIS APPARATUS, BATTERY MANUFACTURING SYSTEM, BATTERY PACK, ELECTRIC VEHICLE, AND DIAGNOSIS METHOD**
DIAGNOSEVORRICHTUNG, BATTERIEHERSTELLUNGSSYSTEM, BATTERIEPACK, ELEKTROFAHRZEUG UND DIAGNOSEVERFAHREN
APPAREIL DE DIAGNOSTIC, SYSTÈME DE FABRICATION DE BATTERIE, BLOC-BATTERIE, VÉHICULE ÉLECTRIQUE ET PROCÉDÉ DE DIAGNOSTIC

(30) Priority: 21.12.2022 KR 20220181101; 13.12.2023 KR 20230181032
(43) Date of publication of application: 08.10.2025
(73) Proprietor: LG Energy Solution, Ltd., Seoul 07335 (KR)
(72) Inventor: CHOI, Soon-Ju, Daejeon 34122 (KR); KIM, Dae-Soo, Daejeon 34122 (KR); KIM, Young-Deok, Daejeon 34122 (KR)
(74) Representative: Goddar, Heinz J.
(86) International application number: PCT/KR2023/020822
(87) International publication number: WO 2024/136350

(56) References cited:
- JP-A- 2017 190 979
- JP-A- 2018 078 023
- JP-A- 2018 078 023
- JP-B2- 6 038 275
- KR-A- 20120 140 671
- KR-A- 20130 126 273
- KR-A- 20130 126 273

## Description

### TECHNICAL FIELD

The present disclosure relates to a technology for diagnosing individual states of a plurality of active materials contained in an electrode for battery.

The present application claims priority to Korean Patent Application No. 10-2022-0181101 filed on December 21, 2022 in the Republic of Korea and Korean Patent Application No. 10-2023-0181032 filed on December 13, 2023 in the Republic of Korea.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Recently, as batteries are used in electric vehicles and storage batteries for energy storage, increasing the energy efficiency of batteries has become one of the important research tasks.

As a means to increase the energy efficiency of the battery, a positive electrode material and/or negative electrode material in which two or more types of active materials are mixed may be used.

Meanwhile, in order to optimize the energy efficiency of the battery, it is necessary to determine whether the battery is manufactured according to design during the manufacturing stage. Specifically, it is necessary to individually diagnose the states of a plurality of active materials during the battery manufacturing stage. In addition, at the use stage, it is necessary to individually diagnose the states of the plurality of active materials according to battery deterioration and appropriately set usage conditions according to the diagnosis results. Specifically, because the mixing ratio of the plurality of active materials included in the electrode changes as the battery deteriorates, it is necessary to individually diagnose the states of the plurality of active materials during the battery use stage.

Therefore, there is a need for technology that may diagnose the individual states of the plurality of active materials included in the electrode for battery.

KR 20130126273 A discloses a method for evaluating characteristics of a blended-electrode of a secondary battery and a system thereof. The method for evaluating characteristics of the blended-electrode of the secondary battery includes the steps of: calculating stoichiometry and capacity or the state of charge (SOC) of each of a plurality of active materials constituting the blended-electrode in correspondence to an equilibrium potential value; calculating each mixing proportion of a plurality of active materials constituting the blended-electrode; detecting the stoichiometry of each active material corresponding to the equilibrium potential value according to the mixing proportion; and calculating the capacity or SOC of the blended-electrode on the basis of the detected stoichiometry of each active material. According to the disclosure, costs and time required in developing the blended-electrode are saved by evaluating the characteristics of the blended-electrode without experiment, when the blended-electrode is produced by mixing a random number of active materials in a random mixing proportion.

### DISCLOSURE

### Technical Problem

The present disclosure is designed to solve the problems of the related art, and therefore the present disclosure is directed to providing a diagnosing apparatus, a manufacturing system, a battery pack, an electric vehicle, and a diagnosing method that may diagnose individual states of active materials included in an electrode for battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

The invention is set out in the appended claims. A diagnosing apparatus according to one aspect of the present disclosure for diagnosing states of first to n^{th} active materials included in an electrode for battery - the electrode is either a positive electrode or a negative electrode - comprises: a profile obtaining unit configured to obtain a target electrode profile representing the corresponding relationship between capacity and voltage of the electrode; and a diagnosing unit configured to generate first to m^{th} simulation electrode profiles based on predetermined first to n^{th} reference active material profiles, individually compare the first to m^{th} simulation electrode profiles with the target electrode profile, and diagnose the states of the first to n^{th} active materials based on the comparative results, wherein n is a natural number of 2 or more, and m is a natural number of 2 or more.

The diagnosing unit may be configured to determine first to n^{th} weighting factors based on the results of individually comparing the first to m^{th} simulation electrode profiles with the target electrode profile.

The diagnosing unit may be configured to determine a characteristic value of a k^{th} active material included in the electrode based on a k^{th} weighting factor associated with the k^{th} active material among the first to n^{th} active materials, wherein k is a natural number less than or equal to n.

The characteristic value may indicate a currently available capacity, a composition ratio within the electrode, or a weight.

The diagnosing unit may be configured to calculate the currently available capacity of the k^{th} active material by multiplying the k^{th} weighting factor by a preset k^{th} reference electrode capacity.

The diagnosing unit may be configured to calculate the composition ratio within the electrode of the k^{th} active material by dividing the k^{th} weighting factor by the sum of all of the first to n^{th} weighting factors.

The diagnosing unit may be configured to calculate the weight of the k^{th} active material by multiplying a preset k^{th} reference weight and the k^{th} weighting factor.

The diagnosing unit may be configured to diagnose the state of the k^{th} active material based on the characteristic value of the k^{th} active material and a preset k^{th} threshold value.

Among the first to n^{th} reference active material profiles, a k^{th} reference active material profile may represent a capacity-voltage relationship obtained in a charging or discharging process of a k^{th} reference electrode, wherein k is a natural number less than or equal to n.

The k^{th} reference electrode may be manufactured to include a single active material that is the same type of active material as the k^{th} active material.

The diagnosing unit may be configured to generate the first to m^{th} simulation electrode profiles by repeating an adjustment procedure and a synthesis procedure for the first to n^{th} reference active material profiles according to first to m^{th} adjustment coefficient sets.

The diagnosing unit may be configured to generate first to n^{th} adjustment active material profiles associated with a j^{th} adjustment coefficient set from the first to n^{th} reference active material profiles by individually using first to n^{th} adjustment coefficients of the j^{th} adjustment coefficient set among the first to m^{th} adjustment coefficient sets, wherein j is a natural number less than or equal to m.

Among the first to n^{th} adjustment active material profiles, the k^{th} adjustment active material profile may be obtained by scaling a k^{th} reference active material profile by a k^{th} adjustment coefficient along a capacity axis.

The diagnosing unit may be configured to generate a j^{th} simulation electrode profile by synthesizing the first to n^{th} adjustment active material profiles associated with the j^{th} adjustment coefficient set.

The diagnosing unit may be configured to determine a simulation electrode profile having a minimum error with the target electrode profile among the first to m^{th} simulation electrode profiles.

The diagnosing unit may be configured to determine first to n^{th} adjustment coefficients of any one of the first to m^{th} adjustment coefficient sets, used in the procedure of generating the determined simulation electrode profile, as the first to n^{th} weighting factors.

The profile obtaining unit may be configured to obtain the target electrode profile based on a measurement full-cell profile representing a capacity-voltage relationship of the battery.

A battery manufacturing system according to another aspect of the present disclosure comprises the diagnosing apparatus according to one aspect of the present disclosure.

A battery pack according to still another aspect of the present disclosure comprises the diagnosing apparatus according to one aspect of the present disclosure.

An electric vehicle according to still another aspect of the present disclosure comprises the diagnosing apparatus according to one aspect of the present disclosure.

A diagnosing method according to still another aspect of the present disclosure for diagnosing states of first to n^{th} active materials included in an electrode for battery, wherein the electrode is either a positive electrode or a negative electrode, comprises:
obtaining a target electrode profile based on capacity-voltage measurement information of the electrode; generating first to m^{th} simulation electrode profiles from first to n^{th} reference active material profiles; and individually comparing the first to m^{th} simulation electrode profiles with the target electrode profile to diagnose the states of the first to n^{th} active materials, wherein n is a natural number of 2 or more, and m is a natural number of 2 or more.

### Advantageous Effects

According to at least one of the embodiments of the present disclosure, it is possible to diagnose individual states of active materials included in an electrode for battery.

In addition, according to at least one of the embodiments of the present disclosure, it is possible to diagnose the state of the electrode and the battery based on the states of the active materials included in the electrode without disassembling the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a diagnosing apparatus according to an embodiment of the present disclosure.
FIG. 2 is a diagram schematically showing an example of a target electrode profile.
FIG. 3 is a diagram schematically showing an example of a first reference active material profile.
FIG. 4 is a diagram schematically showing an example of a second reference active material profile.
FIG. 5 is a diagram schematically showing an example of a simulation electrode profile.
FIG. 6 is a drawing referenced to explain the comparison process between the target electrode profile and the simulation electrode profile.
FIG. 7 is a graph referenced to explain an example of the reference positive electrode profile and the reference negative electrode profile.
FIG. 8 is a graph referenced to explain an example of a measurement full-cell profile.
FIGS. 9 to 11 are diagrams referenced to explain an example of a procedure for generating a comparative full-cell profile used for comparison with a measurement full-cell profile according to an embodiment of the present disclosure.
FIGS. 12 to 14 are diagrams referenced to explain another example of a procedure for generating a comparative full-cell profile used for comparison with a measurement full-cell profile according to an embodiment of the present disclosure.
FIG. 15 is a diagram showing an exemplary configuration of a battery pack according to the present disclosure.
FIG. 16 is a drawing schematically showing an electric vehicle according to the present disclosure.
FIG. 17 is a flowchart illustrating a diagnosing method according to the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Additionally, terms such as "diagnosing unit" described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the attached drawings.

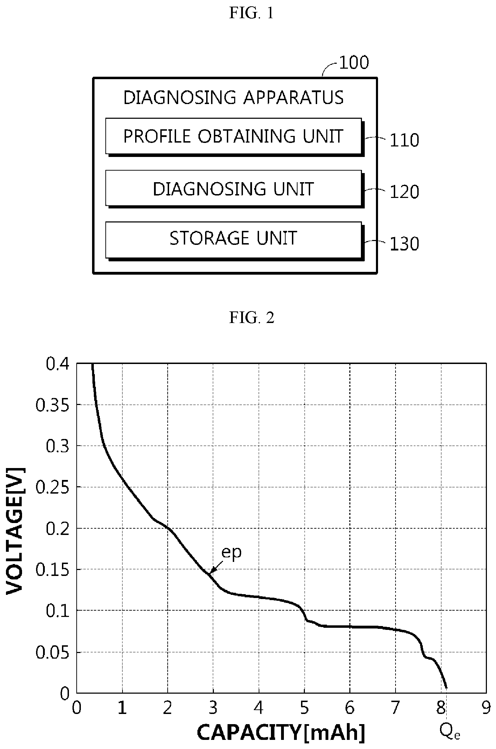

FIG. 1 is a diagram schematically showing a diagnosing apparatus 100 according to an embodiment of the present disclosure.

The diagnosing apparatus 100 is for diagnosing the states of first to n^{th} active materials (n is a natural number of 2 or more) included in an electrode for battery. In this specification, the electrode refers to a positive electrode or a negative electrode. Additionally, the electrode for a battery may refer to an electrode actually included in the battery or an electrode manufactured as a sample before manufacturing the battery.

Here, the battery refers to an independent cell that has a negative electrode terminal and a positive electrode terminal and is physically separable. As an example, a lithium-ion cell or a lithium polymer cell may be considered a battery. Additionally, the type of battery may be cylindrical type, prismatic type, or pouch type. In addition, the battery may mean a battery bank, battery module, or battery pack in which a plurality of cells are connected in series and/or parallel. Hereinafter, for convenience of explanation, the battery is explained as meaning one independent cell.

The first to n^{th} active materials are active materials that constitute an electrode to be diagnosed. Within the electrode, the first to n^{th} active materials may be mixed in unknown proportions.

Referring to FIG. 1, the diagnosing apparatus 100 may include a profile obtaining unit 110 and a diagnosing unit 120.

The profile obtaining unit 110 may be configured to obtain a target electrode profile representing the corresponding relationship between capacity and voltage of the electrode.

Specifically, the target electrode profile may represent the corresponding relationship between the capacity and voltage of the electrode obtained through the charging or discharging process. The voltage of the electrode may mean the difference between a reference potential (e.g., redox potential Li+/Li of lithium ions) and the potential of the electrode.

Hereinafter, for convenience of explanation, it will be assumed that the electrode for battery is a negative electrode.

FIG. 2 is a diagram schematically showing an example of a target electrode profile ep.

In the embodiment of FIG. 2, the horizontal axis (X-axis) represents capacity (Ah), and the vertical axis (Y-axis) represents voltage (V). Referring to FIG. 2, as the voltage decreases as capacity increases, those skilled in the art will easily understand that the target electrode profile ep represents the capacity-voltage relationship of the negative electrode.

As an example, the target electrode profile ep may be generated based on half-cell data obtained through charging or discharging a half-cell including an operating electrode and a reference electrode. The operating electrode may refer to an electrode to be diagnosed, that is, an electrode that participates in charging and discharging reactions. The reference electrode may refer to an electrode that, unlike the operating electrode, provides a reference potential instead of participating in the charging and discharging reaction. The target electrode profile ep generated based on the half-cell data may be obtained at the electrode manufacturing stage. For example, it may be used to diagnose whether the electrode for battery is manufactured according to design requirements.

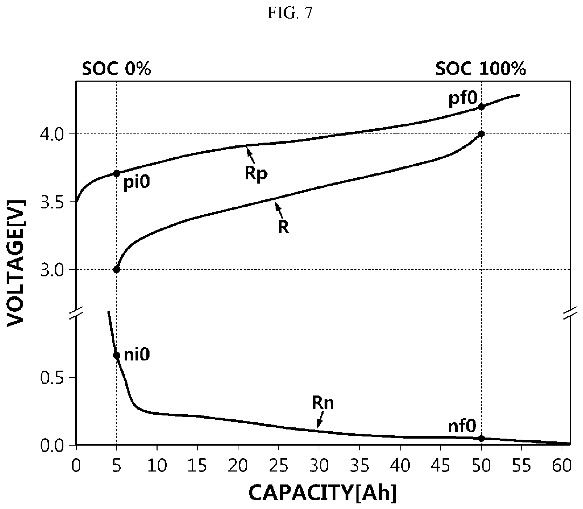

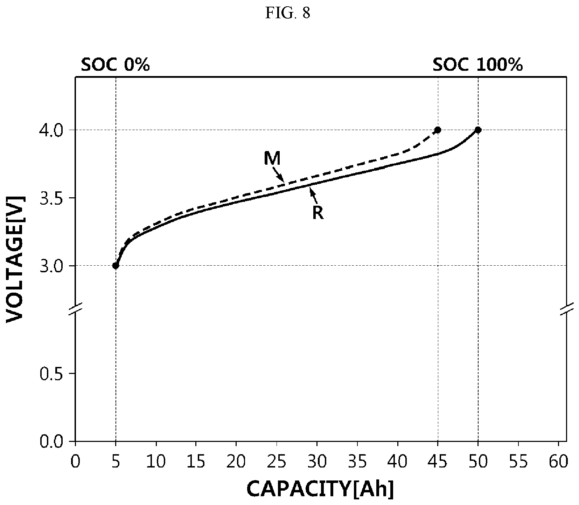

As another example, the target electrode profile ep may be generated based on a measurement full-cell profile (see symbol M in FIG. 8) based on the capacity-voltage information of the battery, a reference positive electrode profile (see symbol Rp in FIG. 7), and a reference negative electrode profile (see symbol Rn in FIG. 7). Here, the reference positive electrode profile may be a profile representing the corresponding relationship between capacity and voltage obtained through charging or discharging for the reference positive electrode. For example, the reference positive electrode may be a positive electrode coin half-cell or a positive electrode of a 3-electrode cell. Additionally, the reference negative electrode profile may be a profile representing the corresponding relationship between capacity and voltage obtained through charging or discharging the reference negative electrode. For example, the reference negative electrode may be a negative electrode coin half-cell or the negative electrode of a 3-electrode cell.

The target electrode profile ep based on the measurement full-cell profile may be obtained at the battery use stage. For example, it may be used to diagnose the deterioration state of the active material contained in the battery electrode.

In this specification, obtaining any data or information should be understood to mean reception from an external device, etc. through a communication means, input from a user, etc. through an input means, or generation through execution of a program, etc.

As an example, the profile obtaining unit 110 may be connected to the outside by wire and/or wirelessly to directly receive the target electrode profile ep. Wired communication may be, for example, CAN (controller area network) communication or CAN-FD (CAN with Flexible Data rate) communication. Wireless communication may be, for example, ZigBee or Bluetooth communication. Of course, as long as it supports communication between the profile obtaining unit 110 and the outside, the type of communication protocol is not particularly limited.

As another example, the profile obtaining unit 110 may receive electrode information about the capacity and voltage of the electrode. Additionally, the profile obtaining unit 110 may generate a target electrode profile ep based on the received electrode information.

As another example, the profile obtaining unit 110 may receive battery capacity-voltage measurement information and obtain a measurement full-cell profile (see M in FIG. 8) based on it. Additionally, the profile obtaining unit 110 may adjust the reference positive electrode profile and reference negative electrode profile to correspond to the measurement full-cell profile, thereby generating the target electrode profile ep. A specific embodiment in which the profile obtaining unit 110 obtains the target electrode profile ep based on the measurement full-cell profile will be described later with reference to FIGS. 7 to 13.

The profile obtaining unit 110 may be connected to communicate with the diagnosing unit 120. For example, the profile obtaining unit 110 may be connected to the diagnosing unit 120 wired and/or wirelessly. The profile obtaining unit 110 may transmit the obtained target electrode profile ep to the diagnosing unit 120.

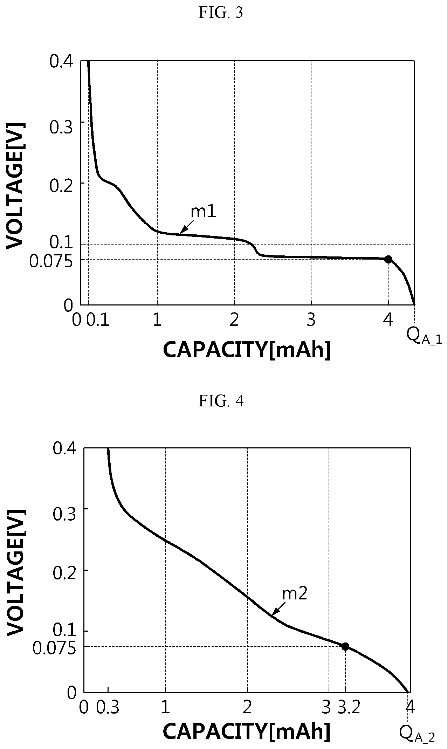

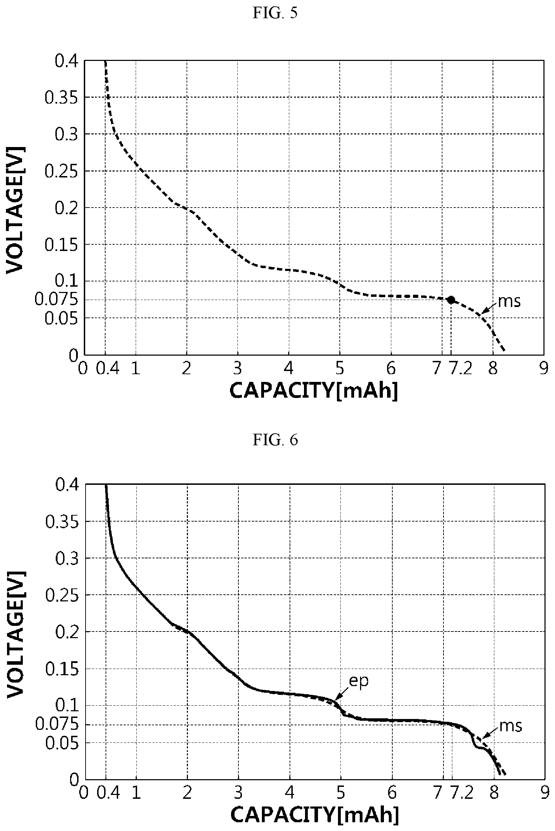

FIG. 3 is a diagram schematically showing an example of a first reference active material profile m1, FIG. 4 is a diagram schematically showing an example of a second reference active material profile m2, FIG. 5 is a diagram schematically showing an example of a simulation electrode profile ms, and FIG. 6 is a drawing referenced to explain the comparison process between the target electrode profile and the simulation electrode profile. For convenience of explanation, FIGS. 3 to 6 are shown assuming that the electrode to be diagnosed is a negative electrode containing a mixed negative electrode material in which two types of active materials (n = 2) are mixed.

In the embodiment of FIGS. 3 to 6, the horizontal axis (X-axis) represents capacity (Ah), and the vertical axis (Y-axis) represents voltage (V).

The diagnosing unit 120 may be configured to generate first to m^{th} simulation electrode profiles (m is a natural number of 2 or more) from predetermined first to n^{th} reference active material profiles.

Here, each of the first to n^{th} reference active material profiles representing the charging or discharging characteristics of the first to n^{th} active materials may be obtained in advance and stored in the storage unit 130, etc.

For example, the reference active material profile of any active material may be obtained by scaling a profile representing the capacity-voltage relationship per unit weight of the active material in a certain voltage range (illustrated as 0 to 0.4 [V] in FIGS. 2 to 4) along the capacity axis by the reference weight of the active material. Here, the reference weight may be individually predetermined for the first to n^{th} active materials. For example, the reference weight of the k^{th} active material may represent the design weight of the k^{th} active material or the initial weight of the k^{th} active material included in the electrode for battery. For reference, the target electrode profile ep may also represent the capacity-voltage relationship of the electrode over the same voltage range.

As another example, the k^{th} reference active material profile (k is a natural number less than or equal to n) among the first to n^{th} reference active material profiles may represent the capacity-voltage relationship obtained in the charging or discharging process of the k^{th} reference electrode. The k^{th} reference electrode may be an electrode manufactured to include a single active material that is the same type of active material as the k^{th} active material. The k^{th} reference electrode may be a coin half-cell, any one electrode of a 3-electrode cell, or any one electrode of a battery.

Specifically, the diagnosing unit 120 may generate a plurality of simulation electrode profiles based on the first to n^{th} reference active material profiles using the plurality of adjustment coefficient sets. Each of the plurality of adjustment coefficient sets may be data defining a mixing ratio between the first to n^{th} reference active material profiles.

Specifically, each adjustment coefficient set includes the same number of adjustment coefficients as the types of active materials constituting the electrode for battery. That is, each adjustment coefficient set includes the first to n^{th} adjustment coefficients. That is, the adjustment coefficient may be assigned to each active material. For example, when the electrode for battery is composed of two types of active materials, each adjustment coefficient set may include a first adjustment coefficient for the first active material and a second adjustment coefficient for the second active material.

The diagnosing unit 120 may generate first to m^{th} simulation electrode profiles by repeating the adjustment procedure and synthesis procedure for the first to n^{th} reference active material profiles according to first to m^{th} adjustment coefficient sets. If m different adjustment coefficient sets are used, m different simulation electrode profiles may be generated.

For example, if j is a natural number less than or equal to m, the diagnosing unit 120 may generate a j^{th} simulation electrode profile by applying the j^{th} adjustment coefficient set to the first to n^{th} reference active material profiles.

Below, the procedure by which the diagnosing unit 120 generates a plurality of simulation electrode profiles from the plurality of reference active material profiles will be described in more detail.

The diagnosing unit 120 may generate first to n^{th} adjustment active material profiles associated with the j^{th} adjustment coefficient set from the first to n^{th} reference active material profiles by individually using the first to n^{th} adjustment coefficients of the j^{th} adjustment coefficient set among the first to m^{th} adjustment coefficient sets.

The diagnosing unit 120 may generate a k^{th} adjustment active material profile associated with the j^{th} adjustment coefficient set by applying the k^{th} adjustment coefficient of the j^{th} adjustment coefficient set to the k^{th} reference active material profile.

That is, the diagnosing unit 120 may generate n adjustment active material profiles by applying each adjustment coefficient set to n reference active material profiles. Accordingly, a total of n × m adjustment active material profiles may be generated based on n reference active material profiles and m adjustment coefficient sets.

For example, when m is 4, j is 1, and n is 3, the diagnosing unit 120 may generate first to third adjustment active material profiles from the first to third reference active material profiles by individually using the first to third adjustment coefficient of the first adjustment coefficient set among the first to fourth adjustment coefficient sets. That is, the diagnosing unit 120 may generate a k^{th} adjustment active material profile associated with the j^{th} adjustment coefficient set from the k^{th} reference active material profile using the k^{th} adjustment coefficient of the j^{th} adjustment coefficient set.

The k^{th} adjustment active material profile associated with the j^{th} adjustment coefficient set may be obtained by scaling the k^{th} reference active material profile by the k^{th} adjustment coefficient of the j^{th} adjustment coefficient set along the capacity axis. For example, the k^{th} adjustment active material profile may be a profile in which the k^{th} reference active material profile is contracted or expanded by the ratio of the k^{th} adjustment coefficient along the capacity axis. If the k^{th} adjustment coefficient is less than 1, the k^{th} adjustment active material profile may be a profile in which the k^{th} reference active material profile is contracted. If the k^{th} adjustment coefficient is greater than 1, the k^{th} adjustment active material profile may be a profile in which the k^{th} reference active material profile is expanded. If the k^{th} adjustment coefficient is 1, the k^{th} adjustment active material profile may be the same profile as the k^{th} reference active material profile.

For example, when the k^{th} adjustment coefficient is 0.8, the k^{th} adjustment active material profile may be a profile in which the k^{th} reference active material profile is contracted at a rate of 0.8 along the capacity axis. That is, for the same voltage, the capacity of the k^{th} adjustment active material profile may be the capacity of the k^{th} reference active material profile multiplied by 0.8.

As another example, when the k^{th} adjustment coefficient is 1.2, the k^{th} adjustment active material profile may be a profile in which the k^{th} reference active material profile is expanded at a rate of 1.2 along the capacity axis. That is, for the same voltage, the capacity of the k^{th} adjustment active material profile may be the capacity of the k^{th} reference active material profile multiplied by 1.2.

Meanwhile, the available capacity of the electrode may be calculated based on the available capacity of each of the first to n^{th} active materials that make up the mixed electrode material of the electrode. Specifically, the available capacity of the electrode may be calculated by adding up the available capacities of all of the first to n^{th} active materials. For example, if the charging or discharging capacity by the first active material is 4 mAh and the charging or discharging capacity by the second active material is 3 mAh, an electrode composed of a mixture of the first active material and the second active material may have an available capacity of 7 mAh.

The k^{th} adjustment coefficient is a value used to generate a k^{th} adjustment active material profile by scaling the k^{th} reference active material profile along the capacity axis. That is, the value obtained by multiplying the available capacity calculated from the k^{th} reference active material profile by the k^{th} adjustment coefficient is the same as the available capacity calculated from the k^{th} adjustment active material profile.

Here, the available capacity of a certain electrode or active material may represent the difference between the capacity corresponding to the lower limit voltage of a predetermined voltage range and the capacity corresponding to the upper limit voltage. Alternatively, when the electrode to be diagnosed is a positive electrode, the available capacity of the electrode or the active material included therein may represent the capacity corresponding to the upper limit voltage. Similarly, when the electrode to be diagnosed is a negative electrode, the available capacity of the electrode or the active material included therein may represent the capacity corresponding to the lower limit voltage.

Also, the k^{th} reference electrode capacity is the available capacity calculated from the k^{th} reference active material profile. The k^{th} reference electrode capacity may be set in advance and stored in the storage unit 130.

For example, the k^{th} reference electrode capacity may be the available capacity in the BOL (Beginning of Life) state of the k^{th} reference electrode. As another example, the k^{th} reference electrode capacity may be the design capacity for the k^{th} active material.

In other words, in order to consider that the first to n^{th} adjustment active material profiles correspond to a profile that reflects the states of the first to n^{th} active materials, the sum of the available capacities respectively calculated from the first to n^{th} adjustment active material profiles must be the same as the available capacity of the electrode. Here, the available capacity of the electrode may be calculated based on the target electrode profile ep. As an example, the difference between the capacity of the target electrode profile ep at the lower limit voltage of a predetermined voltage range and the capacity of the target electrode profile ep at the upper limit voltage may be determined as the available capacity (Qₑ) of the electrode by the diagnosing unit 120.

Accordingly, the diagnosing unit 120 may determine first to m^{th} adjustment coefficient sets based on the available capacity of the electrode and the first to n^{th} reference electrode capacities.

Specifically, the diagnosing unit 120 may determine the first to n^{th} adjustment coefficients of each adjustment coefficient set based on the available capacity of the electrode.

For example, the first to n^{th} adjustment coefficients of each adjustment coefficient set determined by the diagnosing unit 120 may satisfy Formula 1 below. [Formula 1] ${Q}_{e} = {\sum }_{i = 1}^{n} \left({Q}_{A _ i}\times {a}_{i}\right)$

In the above formula, Qₑ represents the available capacity of the electrode, Q_{A_i} represents the i^{th} reference electrode capacity, and aᵢ represents the i^{th} adjustment coefficient.

In each adjustment coefficient set, the i^{th} adjustment coefficient (aᵢ) may have a minimum value of 0 and a maximum value of Qₑ/Q_{A_i}.

Additionally, the diagnosing unit 120 may be configured to generate a j^{th} simulation electrode profile by synthesizing the first to n^{th} adjustment active material profiles associated with the j^{th} adjustment coefficient set among the first to m^{th} adjustment coefficient sets.

For example, when m is 4, j is 1, and n is 3, the diagnosing unit 120 may synthesize the first to third adjustment active material profiles to generate the first simulation electrode profile associated with the first adjustment coefficient set. In this case, 12 adjustment active material profiles and 4 simulation electrode profiles may be generated based on 3 reference active material profiles and 4 adjustment coefficient sets.

Specifically, the diagnosing unit 120 may synthesize the first to n^{th} adjustment active material profiles by summing the capacities of the first to n^{th} adjustment active material profiles for the same voltage. The j^{th} simulation electrode profile may be a profile representing the corresponding relationship between voltage and capacity summed as above.

The first to n^{th} adjustment active material profiles generated using the j^{th} adjustment coefficient set may have a relationship with the j^{th} simulation electrode profile according to Formula 2 below. [Formula 2] ${Q}_{S _ j} \left(V\right) = {\sum }_{i = 1}^{n} {Q}_{i} \left(V\right)$

In the above formula, Q_{S_j} (V) represents the capacity of the j^{th} simulation electrode profile when the voltage is V, and Qᵢ (V) represents the capacity of the i^{th} adjustment active material profile when the voltage is V.

As shown in FIGS. 3 and 4, it is assumed that, according to the first reference active material profile m1, the first active material has a capacity of 0.1 mAh at 0.4 V, and according to the second reference active material profile m2, the second active material has a capacity of 0.3 mAh at 0.4 V.

As an example, if the first and second adjustment coefficients of any one adjustment coefficient set are both 0.5, the diagnosing unit 120 may generate a first adjustment active material profile by applying the adjustment coefficient of 0.5 to the first reference active material profile m1, and generate a second adjustment active material profile by applying the adjustment coefficient of 0.5 to the second reference active material profile m2. Then, the simulation electrode profile generated based on the first adjustment active material profile and the second adjustment active material profile may be based on the data set showing a capacity of {(0.1 × 0.5) + (0.3 × 0.5)} mAh = 0.2 mAh at 0.4 V.

As another example, if the first and second adjustment coefficients of another adjustment coefficient set are 0.2 and 0.8, respectively, the diagnosing unit 120 may generate the first adjustment active material profile by applying the adjustment coefficient of 0.2 to the first reference active material profile m1, and generate the second adjustment active material profile by applying the adjustment coefficient of 0.8 to the second reference active material profile m2. The simulation profile generated based on such adjustment active material profiles may be based on a data set showing a capacity of approximately {(0.1 × 0.2) + (0.3 × 0.8)} mAh = 0.26 mAh at 0.4 V.

The profile ms shown in FIG. 5 is an example of the simulation electrode profile generated by applying a specific adjustment coefficient set including the first adjustment coefficient and the second adjustment coefficient, which are respectively 1, to the first reference active material profile m1 and the second reference active material profile m2.

The diagnosing unit 120 may be configured to individually compare the first to m^{th} simulation electrode profiles with the target electrode profile ep and diagnose the states of the first to n^{th} active materials of the electrode for battery based on the comparative results.

FIG. 6 shows the target electrode profile ep shown in FIG. 2 and the simulation electrode profile ms shown in FIG. 5 together in the same graph.

Specifically, the diagnosing unit 120 may determine first to n^{th} weighting factors based on the results of individually comparing the first to m^{th} simulation electrode profiles with the target electrode profile.

Specifically, the diagnosing unit 120 may determine a simulation electrode profile having a minimum error with the target electrode profile ep among the first to m^{th} simulation electrode profiles.

In relation to this, various methods known at the time of filing the present disclosure may be employed to determine the error between two profiles, each of which can be expressed in a two-dimensional coordinate system. For example, the integral value of the absolute value of the area between two profiles, MSE (Mean Square Error), or RMSE (Root Mean Square Error) may be used as the error between the two profiles. For example, referring to FIG. 6, it can be seen that there is a large error between the two profiles (ep, ms) in the capacity ranges of 4 to 5 mAh and 7.2 to 8 mAh compared to the remaining capacity ranges.

The simulation electrode profile with the minimum error from the target electrode profile may be a profile that best reflects the current state of the electrode among m simulation electrode profiles.

Therefore, each of the first to n^{th} adjustment active material profiles used to generate a simulation electrode profile with minimum error may be strongly assumed to be an active material profile representing the individual current state of the first to n^{th} active materials included in the electrode.

In the prior art, there is a problem in that it is not possible to directly obtain an active material profile indicating the current state of the active material constituting the electrode. On the other hand, the diagnosing apparatus 100 according to the present disclosure has an advantage of indirectly obtaining an active material profile indicating the current state of the active material constituting the electrode.

Additionally, the diagnosing unit 120 may determine the first to n^{th} adjustment coefficients used in the procedure of generating the simulation electrode profile with the minimum error as the first to n^{th} weighting factors.

The k^{th} weighting factor may mean the rate at which the k^{th} adjustment active material profile, which reflects the current state of the k^{th} active material, is changed from the k^{th} reference active material profile. In other words, the k^{th} weighting factor may mean the rate at which the k^{th} adjustment active material profile, which reflects the current state of the k^{th} active material, is changed (e.g., capacity scaling) from the k^{th} reference active material profile.

The diagnosing unit 120 may determine at least one characteristic value of the k^{th} active material included in the electrode, based on the k^{th} weighting factor associated with the k^{th} active material among the first to n^{th} active materials. Here, each characteristic value may represent a currently available capacity, a composition ratio within the electrode, or a weight.

As an example, the diagnosing unit 120 may calculate the currently available capacity of the k^{th} active material by multiplying the k^{th} weighting factor by the k^{th} reference electrode capacity. The diagnosing unit 120 may calculate the currently available capacity of k^{th} active material using Formula 3 below. [Formula 3] ${Q}_{k} = {A}_{k} \times {Q}_{A _ k}$

In the above formula, Qₖ represents the currently available capacity of the k^{th} active material of the electrode, Aₖ represents the k^{th} weighting factor, and Q_{A_k} represents the k^{th} reference electrode capacity.

As another example, the diagnosing unit 120 may calculate the composition ratio within the electrode of the k^{th} active material by dividing the k^{th} weighting factor by the sum of all first to n^{th} weighting factors. The diagnosing unit 120 may calculate the composition ratio of the k^{th} active material within the electrode using Formula 4 below. [Formula 4] ${R}_{k} = \frac{{A}_{k}}{{\sum }_{i = 1}^{n} {A}_{i}}$

In the above formula, Rₖ represents the composition ratio of the k^{th} active material within the electrode.

As another example, the diagnosing unit 120 may calculate the weight of the k^{th} active material included in the electrode by multiplying a preset k^{th} reference weight and the k^{th} weighting factor. Here, the k^{th} reference weight may be the initial weight of the k^{th} active material included in the electrode for battery. As another example, the k^{th} reference weight may be a predetermined weight of the k^{th} active material when manufacturing an electrode for a battery.

The diagnosing unit 120 may be configured to diagnose the state of the k^{th} active material based on the characteristic value of the k^{th} active material and a preset k^{th} threshold value.

Specifically, the diagnosing unit 120 may compare the magnitude between the characteristic value of the k^{th} active material and the k^{th} threshold value and diagnose the state of the k^{th} active material according to the comparative result.

For example, if the characteristic value of the k^{th} active material is greater than or equal to the k^{th} threshold value, the diagnosing unit 120 may diagnose the state of the k^{th} active material as a normal state. Conversely, if the characteristic value of the k^{th} active material is less than the k^{th} threshold value, the diagnosing unit 120 may diagnose the state of the k^{th} active material as an abnormal state.

If the characteristic value is the currently available capacity, at the design stage of the electrode, the diagnosing unit 120 may diagnose an active material that does not express the design capacity as an abnormal state. As another example, in the battery use stage, the diagnosing unit 120 may diagnose an active material in which the currently available capacity of the active material becomes smaller than the threshold value due to battery deterioration as an abnormal state.

The diagnosing apparatus 100 according to the present disclosure has the advantage of being able to individually diagnose the state of the active material by analyzing the characteristic value of each active material included in the electrode for battery.

Meanwhile, each component of the diagnosing apparatus 100 may be physically distinct, or alternatively may be functionally or logically distinct. The profile obtaining unit 110 and the diagnosing unit 120 included in the diagnosing apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the diagnosing unit 120 may be implemented as a set of program modules. At this time, the program module may be stored in the memory and executed by the profile obtaining unit 110 and the diagnosing unit 120. The memory may be inside or outside the profile obtaining unit 110 and the diagnosing unit 120 and may be connected to the profile obtaining unit 110 and the diagnosing unit 120 by various well-known means.

In addition, the diagnosing apparatus 100 may further include a storage unit 130. The storage unit 130 may store data necessary for operation and function of each component of the diagnosing apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the diagnosing unit 120 are defined.

For example, the storage unit 130 may store the first to n^{th} reference active material profiles, the reference positive electrode profile, the reference negative electrode profile, the first to n^{th} reference electrode capacities, and the first to n^{th} threshold values.

The diagnosing unit 120 may be configured to diagnose the state of the electrode based on the diagnosis result of the state of the first to n^{th} active materials.

For example, if the state of at least one of the first to n^{th} active materials is an abnormal state, the diagnosing unit 120 may diagnose the state of the electrode as an abnormal state. Conversely, if the states of the first to n^{th} active materials are all normal, the diagnosing unit 120 may diagnose the state of the electrode as a normal state.

The diagnosing unit 120 may diagnose the state of the battery including the electrode to be diagnosed based on the diagnosis result regarding the state of the electrode. For example, if the positive electrode or negative electrode is in an abnormal state, the diagnosing unit 120 may diagnose that the battery is in an abnormal state. Conversely, if the positive electrode and negative electrode are in a normal state, the diagnosing unit 120 may diagnose that the battery is in a normal state.

The diagnosing apparatus 100 according to the present disclosure has the advantage of being able to diagnose the state of the electrode and/or battery based on the state of the active materials included in the electrode without disassembling the battery. In other words, the battery diagnosing apparatus 100 may diagnose the individual deterioration behavior of the active materials included in the electrode for battery, so the state of the battery may be diagnosed in more detail.

Below, a specific embodiment in which the profile obtaining unit 110 generates a target electrode profile based on the measurement full-cell profile will be described.

FIG. 7 is a graph referenced to explain an example of the reference positive electrode profile Rp and the reference negative electrode profile Rn, and FIG. 8 is a graph referenced to explain an example of a measurement full-cell profile M. In the graphs of FIGS. 7 and 8, the horizontal axis (X-axis) represents capacity (Ah) and the vertical axis (Y-axis) represents voltage (V). For reference, in FIG. 7, etc., the numerical value on the horizontal axis (X axis) represents the capacity of the battery. Therefore, the capacity of any electrode included in the battery should be understood as the capacity at the left end point of the electrode profile of the electrode being 0 Ah.

The measurement full-cell profile M may represent the capacity-voltage relationship of the battery (battery cell) including the electrode to be diagnosed. For example, the measurement full-cell profile M may represent a change in OCV (Open Circuit Voltage) or CCV (Closed Circuit Voltage) according to the change in capacity of the battery (battery cell) during the charging process or discharging process using constant current, constant voltage, or constant power.

The profile obtaining unit 110 may be configured to compare the measurement full-cell profile M and at least one comparative full-cell profile. Here, the comparative full-cell profile may be the result of generating an adjusted positive electrode profile and an adjusted negative electrode profile by adjusting each of the reference positive electrode profile Rp and the reference negative electrode profile Rn stored in the storage unit 130, and then synthesizing (combining) the adjusted positive electrode profile and the adjusted negative electrode profile.

In other words, when the reference full-cell profile R is the result of subtracting a portion of the reference negative electrode profile Rn from a portion of the reference positive electrode profile Rp, the comparative full-cell profile may be said to be the result of subtracting a portion of the adjusted negative electrode profile from a portion of the adjusted positive electrode profile.

The profile obtaining unit 110 may generate at least one comparative full-cell profile by directly adjusting the reference positive electrode profile Rp and the reference negative electrode profile Rn. Alternatively, at least one comparative full-cell profile may be secured in advance based on the reference positive electrode profile Rp and the reference negative electrode profile Rn and stored in the storage unit 130. In this case, the profile obtaining unit 110 may access the storage unit 130 to obtain the comparative full-cell profile in the form of reading.

The profile obtaining unit 110 may generate a plurality of comparative full-cell profiles from the reference positive electrode profile Rp and the reference negative electrode profile Rn by repeating the adjustment procedure in which the reference positive electrode profile Rp and the reference negative electrode profile Rn are respectively adjusted to various levels and then synthesized. The comparative full-cell profile may also be referred to as an 'adjusted reference full-cell profile'.

The profile obtaining unit 110 may specify a comparative full-cell profile having a minimum error from the measurement full-cell profile M among the plurality of comparative full-cell profiles.

Next, the profile obtaining unit 110 may determine that the adjusted positive electrode profile and the adjusted negative electrode profile mapped to a specified comparative full-cell profile are the positive electrode profile and the negative electrode profile of the battery.

In relation to this, various methods known at the time of filing the present disclosure may be employed to determine the error between two profiles, each of which can be expressed in a two-dimensional coordinate system. For example, the integral value of the absolute value of the area between two profiles or RMSE (Root Mean Square Error) may be used as the error between the two profiles.

The finally determined positive electrode profile and negative electrode profile may be mapped to the comparative full-cell profile mapped to the minimum error. In particular, it may be said that the comparative full-cell profile based on the finally determined positive electrode profile and negative electrode profile has almost the same shape as the measurement full-cell profile M.

The finally determined adjustment positive electrode profile and adjustment negative electrode profile may be estimated as the positive electrode profile and negative electrode profile representing the current state of the battery. With current technology, there is a problem in that it is impossible to directly obtain the positive electrode profile and negative electrode profile indicating the current state of the battery without directly disassembling the battery. However, if the diagnosing apparatus 100 according to the present disclosure is used, it can be strongly assumed that the adjustment positive electrode profile and adjustment negative electrode profile, which are the basis of a specified comparative profile, are the positive electrode profile and negative electrode profile that reflect the current state of the battery.

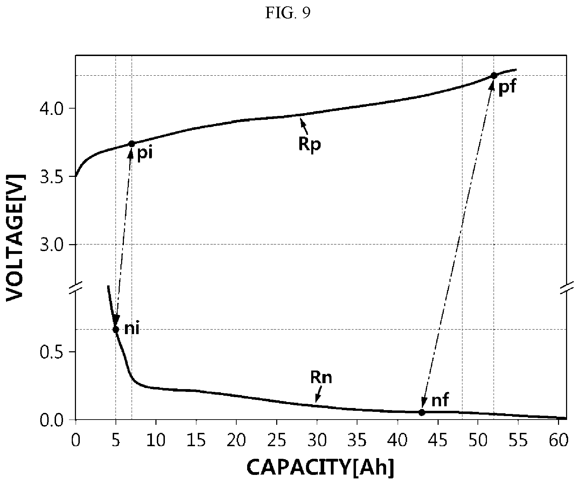

FIGS. 9 to 11 are diagrams referenced to explain an example of a procedure for generating a comparative full-cell profile used for comparison with a measurement full-cell profile M according to an embodiment of the present disclosure.

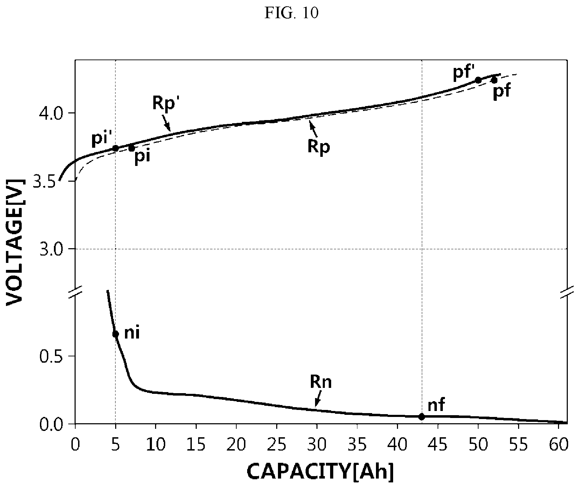

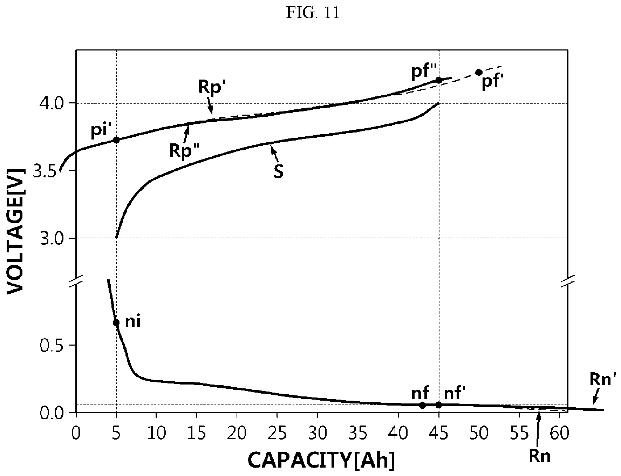

The procedure of generating a comparative full-cell profile, which will be described with reference to FIGS. 9 to 11, proceeds in the following order: a first routine that sets four points (positive electrode participation start point, positive electrode participation end point, negative electrode participation start point, negative electrode participation end point) to correspond to the voltage range of interest (see FIG. 9), a second routine that performs profile shift (see FIG. 10), and a third routine that performs capacity scaling (see FIG. 11). In other words, the procedure for generating a comparative full-cell profile according to an embodiment of the present disclosure includes first to third routines.

First, referring to FIG. 9, the reference positive electrode profile Rp and the reference negative electrode profile Rn are the same as those shown in FIG. 7.

The profile obtaining unit 110 determines a positive electrode participation start point pi, a positive electrode participation end point pf, a negative electrode participation start point ni, and a negative electrode participation end point nf on the reference positive electrode profile Rp and the reference negative electrode profile Rn.

Either the positive electrode participation start point pi or the negative electrode participation start point ni depends on the other.

As an example, the profile obtaining unit 110 may divide the positive electrode voltage range from the start point of the reference positive electrode profile Rp to the end point (or second set voltage) into a plurality of micro voltage sections, and then set the boundary point of the two micro voltage sections to the positive electrode participation start point pi. Each micro voltage section may have a predetermined size (e.g., 0.01 V). Next, the profile obtaining unit 110 may set a point on the reference negative electrode profile Rn that is smaller than the positive electrode participation start point pi by the first set voltage (e.g., 3 V) as the negative electrode participation start point ni.

As another example, the profile obtaining unit 110 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections to the negative electrode participation start point ni. Next, the profile obtaining unit 110 may search for a point greater than the negative electrode participation start point ni by the first set voltage from the reference positive electrode profile Rp and set the searched point as the positive electrode participation start point pi.

Either positive electrode participation end point pf or negative electrode participation end point nf depends on the other.

As an example, the profile obtaining unit 110 may divide the voltage range from the second set voltage to the end point of the reference positive electrode profile Rp into a plurality of micro voltage sections of a predetermined size, and then set the boundary point of two adjacent micro voltage sections among the plurality of micro voltage sections to the positive electrode participation end point pf. Next, the profile obtaining unit 110 may set a point on the reference negative electrode profile Rn that is smaller than the positive electrode participation end point pf by the second set voltage (e.g., 4 V) as the negative electrode participation end point nf.

As another example, the profile obtaining unit 110 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections to the negative electrode participation end point nf. Next, the profile obtaining unit 110 may search for a point greater than the negative electrode participation end point nf by the second set voltage from the reference positive electrode profile Rp and set the searched point as the positive electrode participation end point pf.

Once the determination of the positive electrode participation start point pi, the positive electrode participation end point pf, the negative electrode participation start point ni, and the negative electrode participation end point nf is completed, the profile obtaining unit 110 shifts at least one of the reference positive electrode profile Rp and the reference negative electrode profile Rn to the left or right along the horizontal axis.

Referring to FIG. 10, the profile obtaining unit 110 may shift the reference positive electrode profile Rp to the left (toward low capacity) or shift the negative electrode profile Rn to the right (toward high capacity), or both, so that the capacity values of the positive electrode participation start point pi and the negative electrode participation start point ni match.

Alternatively, the profile obtaining unit 110 may shift the reference positive electrode profile Rp to the left, or shift the reference negative electrode profile Rn to the right, or both, so that the capacity values of the positive electrode participation end point pf and the negative electrode participation end point nf match.

FIG. 10 rates a situation where the capacity value of the positive electrode participation start point pi' matches the capacity value of the negative electrode participation start point ni as a result of generating an adjusted reference positive electrode profile Rp' by shifting only the reference positive electrode profile Rp to the left. The adjusted reference positive electrode profile Rp' is the result of applying an adjustment procedure, which shifts to the left by the capacity value difference between the positive electrode participation start point pi and the negative electrode participation start point ni, to the reference positive electrode profile Rp. Therefore, the two points pi, pi' differ only in capacity values and have the same voltage. The two points pf, pf' differ only in capacity values and have the same voltage.

When the adjustment result profiles Rp', Rn in which at least one of the reference positive electrode profile Rp and the reference negative electrode profile Rn is shifted are secured, the profile obtaining unit 110 scales the capacity range of at least one of the adjustment result profiles Rp', Rn.

According to the example shown in FIG. 10, the profile obtaining unit 110 performs an additional adjustment procedure to contract or expand at least one of the adjusted reference positive electrode profile Rp' and reference negative electrode profile Rn along the horizontal axis.

Referring to FIG. 11, the profile obtaining unit 110 may generate an adjusted reference positive electrode profile Rp" by shrinking or expanding the adjusted reference positive electrode profile Rp' so that the capacity range between two points pi', pf' of the adjusted reference positive electrode profile Rp' matches the capacity range of the measurement full-cell profile M. At this time, one point pi' of the two points pi', pf' may be fixed. Accordingly, the capacity range between the two points pi', pf'' of the adjusted reference positive electrode profile Rp" may match the capacity range of the measurement full-cell profile M.

In addition, the profile obtaining unit 110 may generate an adjusted reference negative electrode profile Rn' by shrinking or expanding the reference negative electrode profile Rn so that the capacity range between the two points ni, nf of the reference negative electrode profile Rn also matches the capacity range of the measurement full-cell profile M. At this time, one point ni of the two points ni, nf may be fixed. Accordingly, the capacity range between the two points ni, nf' of the adjusted reference negative electrode profile Rn' may match the capacity range of the measurement full-cell profile M.

In FIG. 11, the adjusted reference positive electrode profile Rp'' is the result of shrinkage of the adjusted reference positive electrode profile Rp' shown in FIG. 7, and the adjusted reference negative electrode profile Rn' is the result of expanding of the reference negative electrode profile Rn shown in FIG. 10.

The positive electrode participation end point pf'' on the adjusted reference positive electrode profile Rp'' corresponds to the positive electrode participation end point pf' on the adjusted reference positive electrode profile Rp'. The negative electrode participation end point nf' on the adjusted reference negative electrode profile Rn' corresponds to the negative electrode participation end point nf on the reference negative electrode profile Rn.

The capacity range between the positive electrode participation start point pi' and the positive electrode participation end point pf'' of the adjusted reference positive electrode profile Rp" matches the capacity range of the measurement full-cell profile M. Likewise, the capacity range between the negative electrode participation start point ni and the negative electrode participation end point nf' of the adjusted reference negative electrode profile Rn' matches the capacity range of the measurement full-cell profile M.

In addition, the capacity range between the two points pi', pf'' of the adjusted reference positive electrode profile Rp" matches the capacity range between the two points ni, nf' of the adjusted reference negative electrode profile Rn'. The profile obtaining unit 110 may generate a comparative full-cell profile S by subtracting the profile between two points pi', pf'' of the adjusted reference positive electrode profile Rp" from the profile between two points ni, nf' of the adjusted reference negative electrode profile Rn'.

The profile obtaining unit 110 may calculate the error (profile error) between the comparative full-cell profile S and the measurement full-cell profile M.

The profile obtaining unit 110 may map at least two of the adjusted reference positive electrode profile Rp'', the adjusted reference negative electrode profile Rn', the positive electrode participation start point pi', the positive electrode participation end point pf'', the negative electrode participation start point ni, the negative electrode participation end point nf', the first scale factor, the second scale factor, the comparative full-cell profile S, and the profile error with each other and record in the storage unit 130. The first scale factor may represent the ratio of the capacity difference between two points pi', pf'' to the capacity difference between the two points pi0, pf0. The second scale factor may represent the ratio of the capacity difference between two points ni, nf' to the capacity difference between two points ni0, nf0.

Here, the profile obtaining unit 110 may calculate the positive electrode change ratio ps of the reference positive electrode profile Rp'' adjusted to the reference positive electrode profile Rp. Additionally, the profile obtaining unit 110 may calculate the negative electrode change ratio ns of the reference positive electrode profile Rn' adjusted to the reference negative electrode profile Rn. For example, the profile obtaining unit 110 may determine the first scale factor as the positive electrode change ratio ps and determine the second scale factor as the negative electrode change ratio ns.

Meanwhile, as described above, when the positive electrode voltage range of the reference positive electrode profile Rp is divided into a plurality of micro voltage sections, the boundary point of two adjacent micro voltage sections among the plurality of micro voltage sections may be set to the positive electrode participation start point pi.

For example, if the positive electrode voltage range of the reference positive electrode profile Rp is divided into 100 micro voltage ranges, there may be 100 boundary points that can be set as the positive electrode participation start point pi. Additionally, if the voltage range greater than or equal to the second set voltage in the reference positive electrode profile Rp is divided into 40 micro voltage ranges, there may be 40 boundary points that can be set as the positive electrode participation end point pf. In this case, up to 4000 different comparative full-cell profiles can be generated.

Of course, it will be easy to understand that as the size of the micro voltage section decreases, the number of comparative full-cell profiles that can be maximally generated increases, and conversely, as the size of the micro voltage section increases, the number of comparative full-cell profiles that can be maximally generated decreases.

The profile obtaining unit 110 may identify a minimum value among the profile errors of the plurality of comparative full-cell profiles generated as described above, and then obtain the information mapped to the minimum profile error (e.g., at least one of the positive electrode participation start point, the positive electrode participation end point, the negative electrode participation start point, the negative electrode participation end point, the first scale factor, and the second scale factor) from the storage unit 130.

If the comparative full-cell profile S shown in FIG. 11 has the minimum profile error in the measurement full-cell profile M, the adjusted reference positive electrode profile Rp'' or the adjusted reference negative electrode profile Rn' may be used as the target electrode profile.

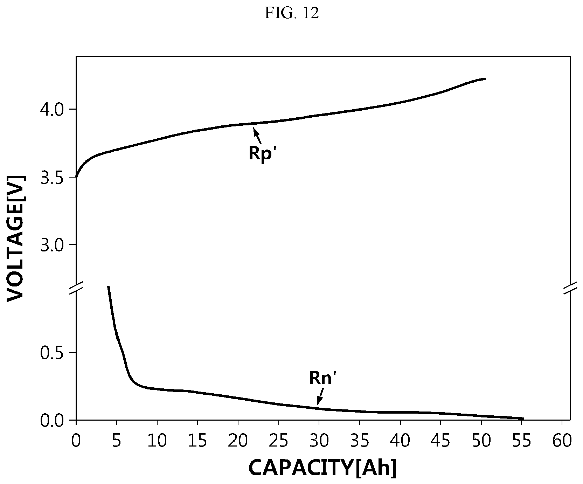

FIGS. 12 to 14 are diagrams referenced to explain another example of a procedure for generating a comparative full-cell profile used for comparison with a measurement full-cell profile M according to an embodiment of the present disclosure. For reference, the embodiment according to FIGS. 12 to 14 is independent from the embodiment according to FIGS. 9 to 11. Accordingly, terms or symbols commonly used in describing the embodiments shown in FIGS. 9 to 11 and the embodiments shown in FIGS. 12 to 14 should be understood as being limited to each embodiment.

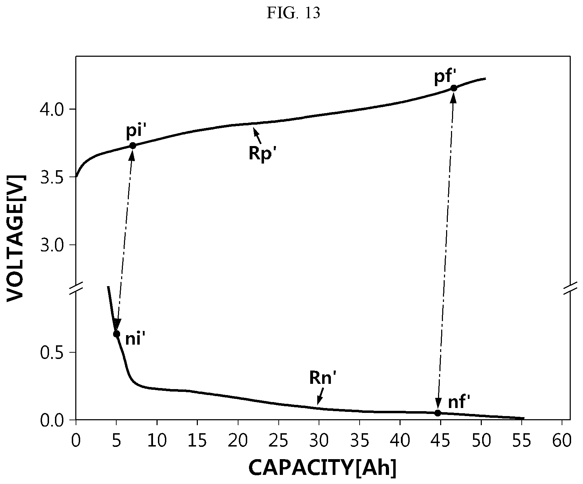

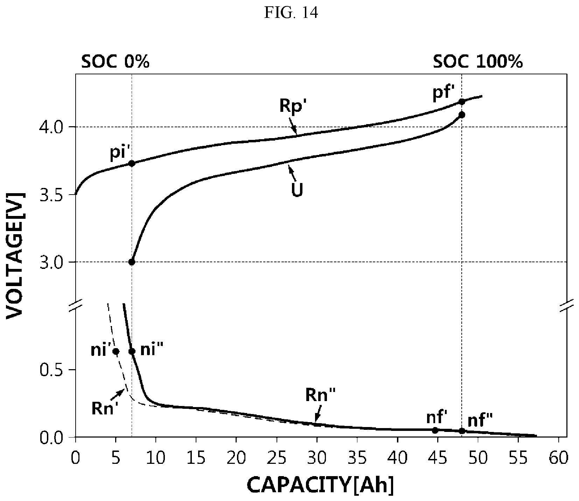

The procedure of generating the comparative full-cell profile to be described with reference to FIGS. 12 to 14 includes a fourth routine that performs capacity scaling (see FIG. 12), a fifth routine that sets four points (positive electrode participation start point, positive electrode participation end point, negative electrode participation start point, negative electrode participation end point) (see FIG. 13), and a sixth routine that performs profile shift (see FIG. 14). That is, the procedure of generating the comparative full-cell profile according to another embodiment of the present disclosure includes the fourth to sixth routines.

Referring to FIG. 12, the reference positive electrode profile Rp and the reference negative electrode profile Rn are the same as those shown in FIG. 7.

The profile obtaining unit 110 generates an adjusted reference positive electrode profile Rp' and an adjusted reference negative electrode profile Rn' by applying the first scale factor and the second scale factor selected from the scaling value range to the reference positive electrode profile Rp and the reference negative electrode profile Rn, respectively.

The scaling value range may be predetermined or may vary depending on the ratio of the size of the capacity range of the measurement full-cell profile M to the size of the capacity range of the reference full-cell profile R. As an example, when it is possible to select the first scale factor and the second scale factor among the values spaced at 0.1% intervals (i.e., 90%, 90.1%, 90.2%, ..., 98.9%, 99%) of the scaling value range (e.g., 90 to 99%), 91 values can be selected as the first scale factor and the second scale factor, respectively. In this case, up to 8,281 adjusted profile pairs can be generated according to 91 × 91 = 8,281 adjustment levels (combination of the first scale factor and the second scale factor). The adjusted profile pair refers to a combination of the adjusted positive electrode profile and the adjusted negative electrode profile.

The adjusted reference positive electrode profile Rp' and the adjusted reference negative electrode profile Rn' shown in FIG. 12 show an example of the results of applying the first scale factor and the second scale factor of less than 100% to the reference positive electrode profile Rp and the reference negative electrode profile Rn, respectively.

Since the first scale factor and the second scale factor are less than 100%, the adjusted reference positive electrode profile Rp' is a contraction of the reference positive electrode profile Rp along the horizontal axis, and the adjusted reference negative electrode profile Rn' is also a contraction of the reference negative electrode profile Rn along the horizontal axis. To facilitate understanding, the drawings are illustrated as a form in which the starting point of each of the positive electrode profile Rp and the reference negative electrode profile Rn is fixed and the remaining portions are reduced to the left along the horizontal axis.

Referring to FIG. 13, the profile obtaining unit 110 determines the positive electrode participation start point pi', the positive electrode participation end point pf', the negative electrode participation start point ni', and the negative electrode participation end point nf' on the adjusted reference positive electrode profile Rp' and the adjusted reference negative electrode profile Rn'.

Either positive electrode participation start point pi' or negative electrode participation start point ni' may depend on the other. Additionally, either positive electrode participation end point pf' or negative electrode participation end point nf' may depend on the other. Additionally, either positive electrode participation start point pi' or positive electrode participation end point pf' may be set based on the other.

That is, when any one of the positive electrode participation start point pi', the positive electrode participation end point pf', the negative electrode participation start point ni', and the negative electrode participation end point nf' is set, the remaining three points may be set automatically by the first set voltage, the second set voltage and/or the size of the capacity range of the measurement full-cell profile M (e.g. charging capacity of SOC 0 to 100%).

As an example, the profile obtaining unit 110 may divide the positive electrode voltage range from the start point of the adjusted reference positive electrode profile Rp' to the end point (or second set voltage) into a plurality of micro voltage section, and then set the boundary point of two adjacent micro voltage sections among the plurality of micro voltage sections to the positive electrode participation start point pi'. Next, the profile obtaining unit 110 may set a point on the adjusted reference negative electrode profile Rn that is smaller than the positive electrode participation start point pi' by the first set voltage (e.g., 3 V) as the negative electrode participation start point ni'.

As another example, the profile obtaining unit 110 may divide the negative electrode voltage range from the start point to the end point of the adjusted reference negative electrode profile Rn' into a plurality of micro voltage sections of a predetermined size, and then set the boundary point of two adjacent micro voltage sections among the plurality of micro voltage sections to the negative electrode participation start point ni'. Next, the profile obtaining unit 110 may search for a point greater than the negative electrode participation start point ni' by the first set voltage from the adjusted reference positive electrode profile Rp' and set the searched point as the positive electrode participation start point pi'.

As still another example, the profile obtaining unit 110 may divide the voltage range from the second set voltage to the end point of the adjusted reference positive electrode profile Rp' into a plurality of micro voltage sections of a predetermined size, and then set the boundary point of two micro voltage sections among the plurality of micro voltage sections to the positive electrode participation end point pf'. Next, the profile obtaining unit 110 may search for a point smaller than the positive electrode participation end point pf' by the second set voltage (e.g., 4 V) in the adjusted reference negative electrode profile Rn', and set the searched point as the negative electrode participation end point 'nf'.

As still another example, the profile obtaining unit 110 may divide the negative electrode voltage range from the start point to the end point of the adjusted reference negative electrode profile Rn' into a plurality of micro voltage sections of a predetermined size, and then set the boundary point of two micro voltage sections among the plurality of micro voltage sections to the negative electrode participation end point nf'. Next, the profile obtaining unit 110 may search for a point greater than the negative electrode participation end point nf' by the second set voltage from the adjusted reference positive electrode profile Rp' and set the searched point as positive electrode participation end point pf'.

When any one of the positive electrode participation start point pi', the positive electrode participation end point pf', the negative electrode participation start point ni', and the negative electrode participation end point nf' is determined, the profile obtaining unit 110 may additionally determine the remaining three points based on the determined point.

As an example, when the positive electrode participation start point pi' is determined first, the profile obtaining unit 110 may set a point on the adjusted reference positive electrode profile Rp', which has a capacity value larger than the capacity value of the positive electrode participation start point pi' by the size of the capacity range of the measurement full-cell profile M, as the positive electrode participation end point pf'. In addition, the profile obtaining unit 110 may search for a point lower than the voltage of the positive electrode participation start point pi' by the first set voltage from the adjusted reference negative electrode profile Rn' and set the searched point as the negative electrode participation start point ni'. In addition, the profile obtaining unit 110 may set a point on the adjusted reference negative electrode profile Rn', which has a capacity value greater than the capacity value of the negative electrode participation start point ni' by the size of the capacity range of the measurement full-cell profile M, as the negative electrode participation end point nf'.

As another example, when the positive electrode participation end point pf' is determined first, the profile obtaining unit 110 may set a point on the adjusted reference positive electrode profile Rp', which has a capacity value smaller than the capacity value of the positive electrode participation end point pf' by the size of the capacity range of the measurement full-cell profile M, as the positive electrode participation start point pi'. In addition, the profile obtaining unit 110 may search for a point lower than the voltage of positive electrode participation end point pf' by the second set voltage from the adjusted reference negative electrode profile Rn' and set the searched point as the negative electrode participation end point nf'. In addition, the profile obtaining unit 110 may set a point on the adjusted reference negative electrode profile Rn', which has a capacity value smaller than the capacity value of the negative electrode participation end point nf' by the size of the capacity range of the measurement full-cell profile M, as the negative electrode participation start point ni'.

As still another example, when the negative electrode participation start point ni' is determined, the profile obtaining unit 110 may set a point on the reference negative electrode profile Rn', which has a capacity value greater than the capacity value of the negative electrode participation start point ni' by the size of the capacity range of the measurement full-cell profile M, as the negative electrode participation end point nf'. In addition, the profile obtaining unit 110 may search for a point higher than the voltage of the negative electrode participation start point ni' by the first set voltage from the adjusted reference positive electrode profile Rp' and set the searched point as the positive electrode participation start point pi'. In addition, the profile obtaining unit 110 may set a point on the adjusted reference positive electrode profile Rp', which has a capacity value greater than the capacity value of the positive electrode participation start point pi' by the size of the capacity range of the measurement full-cell profile M, as the positive electrode participation end point pf'.

As still another example, when the negative electrode participation end point nf' is determined, the profile obtaining unit 110 may set a point on the reference negative electrode profile Rn', which has a capacity value smaller than the capacity value of the negative electrode participation end point nf' by the size of the capacity range of the measurement full-cell profile M, as the negative electrode participation start point ni'. In addition, the profile obtaining unit 110 may search for a point higher than the voltage of the negative electrode participation end point nf' by the second set voltage from the adjusted reference positive electrode profile Rp' and set the searched point as the positive electrode participation end point pf'. In addition, the profile obtaining unit 110 may set a point on the adjusted reference positive electrode profile Rp', which has a capacity value smaller than the capacity value of the positive electrode participation end point pf' by the size of the capacity range of the measurement full-cell profile M, as the positive electrode participation start point pi'.

Once the determination of the positive electrode participation start point pi', the positive electrode participation end point pf', the negative electrode participation start point ni' and the negative electrode participation end point nf' is completed based on the pair of first scale factor and second scale factor, the profile obtaining unit 110 may shift at least one of the adjusted reference positive electrode profile Rp' and the adjusted reference negative electrode profile Rn' to the left or right along the horizontal axis so that the capacity values of the positive electrode participation start point pi' and the negative electrode participation start point ni' match or the capacity values of the positive electrode participation end point pf' and the negative electrode participation end point nf' match.

The adjusted reference negative electrode profile Rn" shown in FIG. 14 is obtained by shifting only the adjusted reference negative electrode profile Rn' shown in FIG. 13 to the right. Accordingly, the capacity values of the positive electrode participation start point pi' and the negative electrode participation start point ni" match each other. In relation to this, since the capacity difference between the positive electrode participation start point pi' and the positive electrode participation end point pf' is the same as the capacity difference between the negative electrode participation start point ni' and the negative electrode participation end point nf', if the capacity values of the positive electrode participation start point pi' and the negative electrode participation start point ni" match each other, the capacity values of the positive electrode participation end point pf' and the negative electrode participation end point nf" also match each other.

Referring to FIG. 14, the profile obtaining unit 110 may generate a comparative full-cell profile U by subtracting the partial profile between two points pi', pf' of the adjusted reference positive electrode profile Rp' from the partial profile between two points ni'', nf'' of the adjusted reference negative electrode profile Rn''.

The profile obtaining unit 110 may calculate the error (profile error) between the comparative full-cell profile U and the measurement full-cell profile M.

The profile obtaining unit 110 may map at least two of the adjusted reference positive electrode profile Rp', the adjusted reference negative electrode profile Rn", the positive electrode participation start point pi', the positive electrode participation end point pf', the negative electrode participation start point ni'', the negative electrode participation end point nf", the first scale factor, the second scale factor, the comparative full-cell profile U, and the profile error with each other and record in the storage unit 130.

Here, the profile obtaining unit 110 may calculate the positive electrode change ratio ps of the reference positive electrode profile Rp' adjusted to the reference positive electrode profile Rp. Additionally, the profile obtaining unit 110 may calculate the negative electrode change ratio ns of the reference positive electrode profile Rn" adjusted to the reference negative electrode profile Rn. For example, the profile obtaining unit 110 may determine the first scale factor as the positive electrode change ratio ps and determine the second scale factor as the negative electrode change ratio ns.

As described above, the profile obtaining unit 110 may generate a comparative full-cell profile corresponding to each pair of first scale factor and second scale factor selected from the scaling value range. Since the pair of first scale factor and second scale factor is plural, it is obvious that the comparative full-cell profile will also be generated in plural. The profile obtaining unit 110 may identify the minimum value among the profile errors of the plurality of comparative full-cell profiles and then obtain information mapped to the minimum profile error from the storage unit 130.

If the comparative full-cell profile U shown in FIG. 14 has the minimum profile error in the measurement full-cell profile M, the adjusted reference positive electrode profile Rp' or the adjusted reference negative electrode profile Rn" may be used as the target electrode profile.

The diagnosing apparatus 100 according to an embodiment of the present disclosure may be included in a battery manufacturing system (not shown).

Here, the battery manufacturing system may be a system applied to the battery manufacturing process. For example, the battery may be manufactured to include an electrode assembly, an exterior material, and an electrolyte solution. The exterior material provides a space in which the electrode assembly can be accommodated, and the electrode assembly may be at least partially impregnated by injection of an electrolyte solution into the space. Also, by finally sealing the exterior material, the manufacturing of the battery may be completed. Afterwards, the battery may be completed through an activation process and a degassing process.

Also, the state of the manufactured battery may be diagnosed by the diagnosing apparatus 100. Preferably, the state of the battery may be diagnosed based on the state of the active material included in the manufactured electrode for battery.

The battery manufacturing system according to an embodiment of the present disclosure may diagnose whether the manufactured battery is a good product by diagnosing the state of the active material included in the manufactured electrode.

The diagnosing apparatus 100 according to the present disclosure may be applied to a battery management system (BMS). That is, the BMS according to the present disclosure may include the apparatus 100 for diagnosing a battery described above. In this configuration, at least some of components of the diagnosing apparatus 100 may be implemented by supplementing or adding functions of the components included in a conventional BMS. For example, the profile obtaining unit 110, the diagnosing unit 120 and the storage unit 130 of the diagnosing apparatus 100 may be implemented as components of the BMS.

Additionally, the diagnosing apparatus 100 according to the present disclosure may be provided in the battery pack. That is, the battery pack according to the present disclosure may include the above-described diagnosing apparatus 100 and at least one battery cell. Additionally, the battery pack may further include electrical components (relays, fuses, etc.) and a case.

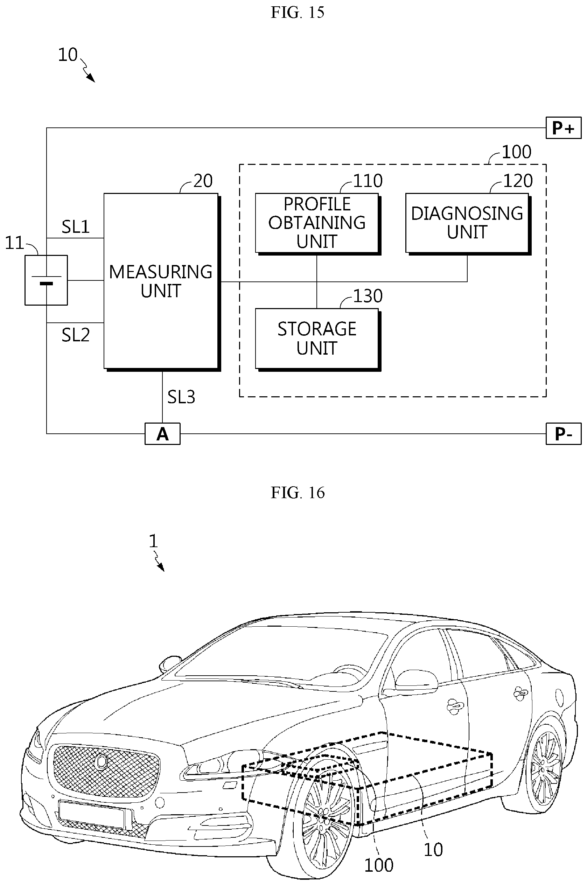

FIG. 15 is a diagram showing an exemplary configuration of a battery pack 10 according to the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 20 may be connected to a first sensing line SL1, a second sensing line SL2 and a third sensing line SL3. Specifically, the measuring unit 20 may be connected to the positive electrode terminal of the battery 11 through the first sensing line SL1, and may be connected to the negative electrode terminal of the battery 11 through the second sensing line SL2. The measuring unit 20 may measure the voltage of the battery 11 based on the voltage measured at each of the first sensing line SL1 and the second sensing line SL2.

In addition, the measuring unit 20 may be connected to the current measurement unit A through the third sensing line SL3. For example, the current measurement unit A may be an ammeter or shunt resistor that may measure the charging current and discharging current of the battery 11. The measuring unit 20 may calculate the charging amount by measuring the charging current of the battery 11 through the third sensing line SL3. Additionally, the measuring unit 20 may calculate the discharging amount by measuring the discharging current of the battery 11 through the third sensing line SL3.

One end of an external device (not shown) may be connected to the positive electrode terminal P+ of the battery pack 10, and the other end may be connected to the negative electrode terminal P- of the battery pack 10. Therefore, the positive electrode terminal of the battery 11, the positive electrode terminal P+ of the battery pack 10, the external device, the negative electrode terminal P- of the battery pack 10, and the negative electrode terminal of the battery 11 may be electrically connected.

For example, the external device may be a charging device, or a load such as a motor of an electric vehicle that receives power from the battery 11.

FIG. 16 is a diagram schematically showing an electric vehicle 1 according to the present disclosure.

Referring to FIG. 16, the battery pack 10 according to an embodiment of the present disclosure may be included in the electric vehicle 1 such as an electric vehicle (EV) or a hybrid vehicle (HV). Here, the battery pack 10 described above may be applied as the battery pack 10. Additionally, the battery pack 10 may drive the electric vehicle 1 by supplying power to the motor through an inverter provided in the electric vehicle 1. Additionally, the battery pack 10 may include the diagnosing apparatus 100 according to an embodiment of the present disclosure. That is, the electric vehicle 1 may include the diagnosing apparatus 100.

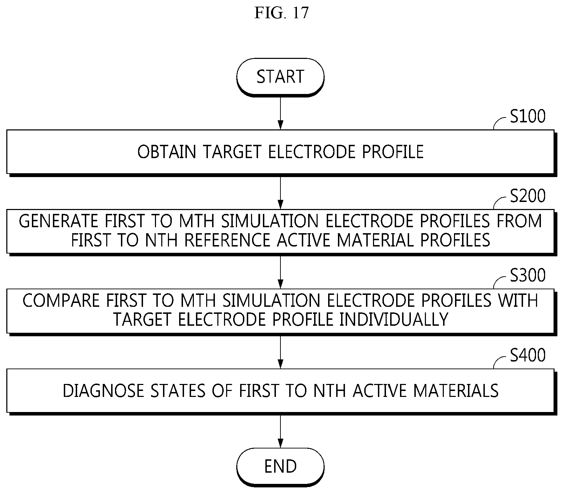

FIG. 17 is a flowchart illustrating a diagnosing method according to the present disclosure.

The diagnosing method according to an embodiment of the present disclosure is a method for diagnosing the individual states of the first to n^{th} active materials (n is a natural number of 2 or more) included in an electrode for battery. Here, the electrode refers to a positive electrode or a negative electrode.

Preferably, each step of the diagnosing method may be performed by the diagnosing apparatus 100. Hereinafter, for convenience of explanation, the content overlapping with the previously described content will be briefly described or omitted.

Referring to FIG. 17, in step S 100, the profile obtaining unit 110 may obtain a target electrode profile ep based on capacity-voltage measurement information of the electrode.

For example, the target electrode profile ep may be generated based on half-cell data obtained through charging or discharging the half-cell. As another example, the target electrode profile ep may be generated based on the measurement full-cell profile, the reference positive electrode profile, and the reference negative electrode profile based on the battery capacity-voltage information.

In step S200, the diagnosing unit 120 may generate first to m^{th} simulation electrode profiles (m is a natural number of 2 or more) from the first to n^{th} reference active material profiles.

Specifically, the diagnosing unit 120 may generate first to n^{th} adjustment active material profiles associated with the j^{th} adjustment coefficient set from the first to n^{th} reference active material profiles by individually using the first to n^{th} adjustment coefficients of the j^{th} adjustment coefficient set (j is a natural number less than or equal to m) among the first to m^{th} adjustment coefficient sets. For example, the k^{th} adjustment active material profile may be a profile in which the k^{th} reference active material profile is scaled by the k^{th} adjustment coefficient along the capacity axis. Additionally, the diagnosing unit 120 may be configured to generate a j^{th} simulation electrode profile by synthesizing the first to n^{th} adjustment active material profiles associated with the j^{th} adjustment coefficient set.

In step S300, the diagnosing unit 120 may individually compare the first to m^{th} simulation electrode profiles with the target electrode profile ep.

For example, the diagnosing unit 120 may determine a simulation electrode profile that has a minimum error with the target electrode profile ep among the first to m^{th} simulation electrode profiles.

In step S400, the diagnosing unit 120 may diagnose the state of the first to n^{th} active materials.

Specifically, the diagnosing unit 120 may determine the first to n^{th} adjustment coefficients used in the procedure of generating the simulation electrode profile determined in step S300 as first to n^{th} weighting factors. Additionally, the diagnosing unit 120 may determine the characteristic value of the k^{th} active material based on the k^{th} weighting factor associated with the k^{th} active material among the first to n^{th} active materials. Here, the characteristic value may be a currently available capacity, a composition ratio within the electrode, or a weight. The diagnosing unit 120 may diagnose the state of the k^{th} active material based on the characteristic value of the k^{th} active material and a preset k^{th} threshold value.

More specifically, the diagnosing unit 120 may calculate the currently available capacity of the k^{th} active material by multiplying the k^{th} weighting factor by the k^{th} reference electrode capacity (see Formula 3). The diagnosing unit 120 may calculate the composition ratio within the electrode of the k^{th} active material by dividing the k^{th} weighting factor by the sum of all of the first to n^{th} weighting factors (see Formula 4). If the k^{th} reference active material profile represents the capacity-voltage relationship per unit weight of the k^{th} active material, the diagnosing unit 120 may calculate the weight of the k^{th} active material by multiplying the unit weight and the k^{th} weighting factor (Aₖ).

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings.

## Claims

1. A diagnosing apparatus (100) for diagnosing states of first to n^{th} active materials included in an electrode for battery (11) - the electrode is either a positive electrode or a negative electrode, the diagnosing apparatus (100) comprising:
a profile obtaining unit (110) configured to obtain a target electrode profile representing the corresponding relationship between capacity and voltage of the electrode; and **characterised by**
a diagnosing unit (120) configured to generate first to m^{th} simulation electrode profiles based on predetermined first to n^{th} reference active material profiles, individually compare the first to m^{th} simulation electrode profiles with the target electrode profile, and diagnose the states of the first to n^{th} active materials based on the comparative results,
wherein n is a natural number of 2 or more, and m is a natural number of 2 or more.

2. The diagnosing apparatus (100) according to claim 1,
wherein the diagnosing unit (120) is configured to:
determine first to n^{th} weighting factors based on the results of individually comparing the first to m^{th} simulation electrode profiles with the target electrode profile, and
determine a characteristic value of a k^{th} active material included in the electrode based on a k^{th} weighting factor associated with the k^{th} active material among the first to n^{th} active materials,
wherein k is a natural number less than or equal to n,
wherein the characteristic value indicates a currently available capacity, a composition ratio within the electrode, or a weight.

3. The diagnosing apparatus (100) according to claim 2,
wherein the diagnosing unit (120) is configured to calculate the currently available capacity of the k^{th} active material by multiplying the k^{th} weighting factor by a preset k^{th} reference electrode capacity.

4. The diagnosing apparatus (100) according to claim 2,
wherein the diagnosing unit (120) is configured to calculate the composition ratio within the electrode of the k^{th} active material by dividing the k^{th} weighting factor by the sum of all of the first to n^{th} weighting factors.

5. The diagnosing apparatus (100) according to claim 2,
wherein the diagnosing unit (120) is configured to calculate the weight of the k^{th} active material by multiplying a preset k^{th} reference weight and the k^{th} weighting factor.

6. The diagnosing apparatus (100) according to claim 2,
wherein the diagnosing unit (120) is configured to diagnose the state of the k^{th} active material based on the characteristic value of the k^{th} active material and a preset k^{th} threshold value.

7. The diagnosing apparatus (100) according to claim 1,
wherein among the first to n^{th} reference active material profiles, a k^{th} reference active material profile represents a capacity-voltage relationship obtained in a charging or discharging process of a k^{th} reference electrode, and
wherein the k^{th} reference electrode is manufactured to include a single active material that is the same type of active material as the k^{th} active material,
and k is a natural number less than or equal to n.

8. The diagnosing apparatus (100) according to claim 2,
wherein the diagnosing unit (120) is configured to generate the first to m^{th} simulation electrode profiles by repeating an adjustment procedure and a synthesis procedure for the first to n^{th} reference active material profiles according to first to m^{th} adjustment coefficient sets.

9. The diagnosing apparatus (100) according to claim 8,
wherein the diagnosing unit (120) is configured to:
as the adjustment procedure, generate first to n^{th} adjustment active material profiles associated with a j^{th} adjustment coefficient set from the first to n^{th} reference active material profiles by individually using first to n^{th} adjustment coefficients of the j^{th} adjustment coefficient set among the first to m^{th} adjustment coefficient sets, and
as the synthesis procedure, generate a j^{th} simulation electrode profile by synthesizing the first to n^{th} adjustment active material profiles associated with the j^{th} adjustment coefficient set,
wherein among the first to n^{th} adjustment active material profiles, the k^{th} adjustment active material profile is obtained by scaling a k^{th} reference active material profile by a k^{th} adjustment coefficient along a capacity axis,
and j is a natural number less than or equal to m.

10. The diagnosing apparatus (100) according to claim 9,
wherein the diagnosing unit (120) is configured to:
determine a simulation electrode profile having a minimum error with the target electrode profile among the first to m^{th} simulation electrode profiles, and
determine first to n^{th} adjustment coefficients of any one of the first to m^{th} adjustment coefficient sets, used in the procedure of generating the determined simulation electrode profile, as the first to n^{th} weighting factors.

11. The diagnosing apparatus (100) according to claim 1,
wherein the profile obtaining unit (110) is configured to obtain the target electrode profile based on a measurement full-cell profile representing a capacity-voltage relationship of the battery (11).

12. A battery manufacturing system, comprising the diagnosing apparatus (100) according to any one of claims 1 to 11.

13. A battery pack (10), comprising the diagnosing apparatus (100) according to any one of claims 1 to 11.

14. An electric vehicle, comprising the diagnosing apparatus (100) according to any one of claims 1 to 11.

15. A diagnosing method performed by a diagnosing apparatus (100) for diagnosing states of first to n^{th} active materials included in an electrode for battery (11), wherein the electrode is either a positive electrode or a negative electrode, the diagnosing method comprising:
obtaining a target electrode profile based on capacity-voltage measurement information of the electrode;
**characterised by**
generating first to m^{th} simulation electrode profiles from first to n^{th} reference active material profiles; and
individually comparing the first to m^{th} simulation electrode profiles with the target electrode profile to diagnose the states of the first to n^{th} active materials,
wherein n is a natural number of 2 or more, and m is a natural number of 2 or more.

## Patentansprüche

1. Diagnosevorrichtung (100) zum Diagnostizieren von Zuständen von ersten bis n-ten aktiven Materialien, die in einer Elektrode für eine Batterie (11) enthalten sind - die Elektrode ist entweder eine positive Elektrode oder eine negative Elektrode, wobei die Diagnosevorrichtung (100) umfasst:
eine Profilerfassungseinheit (110), die konfiguriert ist, um ein Zielelektrodenprofil zu erhalten, das die entsprechende Beziehung zwischen Kapazität und Spannung der Elektrode darstellt; und **gekennzeichnet durch**
eine Diagnoseeinheit (120), die konfiguriert ist, um erste bis m-te Simulationselektrodenprofile basierend auf vorbestimmten ersten bis n-ten Referenzprofilen für aktive Materialien zu erzeugen, die ersten bis m-ten Simulationselektrodenprofile einzeln mit dem Zielelektrodenprofil zu vergleichen und die Zustände der ersten bis n-ten aktiven Materialien basierend auf den Vergleichsergebnissen zu diagnostizieren,
wobei n eine natürliche Zahl von 2 oder mehr ist und m eine natürliche Zahl von 2 oder mehr ist.

2. Diagnosevorrichtung (100) nach Anspruch 1,
wobei die Diagnoseeinheit (120) konfiguriert ist zum:
Bestimmen von ersten bis n-ten Gewichtungsfaktoren basierend auf den Ergebnissen des individuellen Vergleichens der ersten bis m-ten Simulationselektrodenprofile mit dem Zielelektrodenprofil, und
Bestimmen eines charakteristischen Wertes eines k-ten aktiven Materials, das in der Elektrode enthalten ist, basierend auf einem k-ten Gewichtungsfaktor, der dem k-ten aktiven Material unter den ersten bis n-ten aktiven Materialien zugeordnet ist,
wobei k eine natürliche Zahl kleiner oder gleich n ist,
wobei der charakteristische Wert eine aktuell verfügbare Kapazität, ein Zusammensetzungsverhältnis innerhalb der Elektrode oder eine Gewichtung angibt.

3. Diagnosevorrichtung (100) nach Anspruch 2,
wobei die Diagnoseeinheit (120) konfiguriert ist, um die aktuell verfügbare Kapazität des k-ten aktiven Materials durch Multiplizieren des k-ten Gewichtungsfaktors mit einer voreingestellten k-ten Referenzelektrodenkapazität zu berechnen.

4. Diagnosevorrichtung (100) nach Anspruch 2,
wobei die Diagnoseeinheit (120) konfiguriert ist, um das Zusammensetzungsverhältnis innerhalb der Elektrode des k-ten aktiven Materials durch Dividieren des k-ten Gewichtungsfaktors durch die Summe aller ersten bis n-ten Gewichtungsfaktoren zu berechnen.

5. Diagnosevorrichtung (100) nach Anspruch 2,
wobei die Diagnoseeinheit (120) konfiguriert ist, um die Gewichtung des k-ten aktiven Materials durch Multiplizieren eines voreingestellten k-ten Referenzgewichts und des k-ten Gewichtungsfaktors zu berechnen.

6. Diagnosevorrichtung (100) nach Anspruch 2,
wobei die Diagnoseeinheit (120) konfiguriert ist, um den Zustand des k-ten aktiven Materials basierend auf dem charakteristischen Wert des k-ten aktiven Materials und einem voreingestellten k-ten Schwellenwert zu diagnostizieren.

7. Diagnosevorrichtung (100) nach Anspruch 1,
wobei unter den ersten bis n-ten Referenzprofilen für aktive Materialien ein k-tes Referenzprofil für aktive Materialien eine Kapazität-Spannung-Beziehung darstellt, die in einem Lade- oder Entladeprozess einer k-ten Referenzelektrode erhalten wird, und
wobei die k-te Referenzelektrode so hergestellt ist, dass sie ein einzelnes aktives Material enthält, das die gleiche Art von aktivem Material wie das k-te aktive Material ist,
und k eine natürliche Zahl kleiner oder gleich n ist.

8. Diagnosevorrichtung (100) nach Anspruch 2,
wobei die Diagnoseeinheit (120) konfiguriert ist, um die ersten bis m-ten Simulationselektrodenprofile durch Wiederholen eines Anpassungsvorgangs und eines Synthesevorgangs für die ersten bis n-ten Referenzprofile für aktive Materialien gemäß ersten bis m-ten Anpassungskoeffizientensätzen zu erzeugen.

9. Diagnosevorrichtung (100) nach Anspruch 8,
wobei die Diagnoseeinheit (120) konfiguriert ist zum:
als den Anpassungsvorgang, Erzeugen von ersten bis n-ten Anpassungsprofilen für aktive Materialien, die einem j-ten Anpassungskoeffizientensatz aus den ersten bis n-ten Referenzprofilen für aktive Materialien zugeordnet sind, durch individuelles Verwenden von ersten bis n-ten Anpassungskoeffizienten des j-ten Anpassungskoeffizientensatzes unter den ersten bis m-ten Anpassungskoeffizientensätzen, und
als den Synthesevorgang, Erzeugen eines j-ten Simulationselektrodenprofils durch Synthetisieren der ersten bis n-ten Anpassungsprofile für aktive Materialien, die dem j-ten Anpassungskoeffizientensatz zugeordnet sind,
wobei unter den ersten bis n-ten Anpassungsprofilen für aktive Materialien das k-te Anpassungsprofil für aktive Materialien durch Skalieren eines k-ten Referenzprofils für aktive Materialien mit einem k-ten Anpassungskoeffizienten entlang einer Kapazitätsachse erhalten wird,
und j eine natürliche Zahl kleiner oder gleich m ist.

10. Diagnosevorrichtung (100) nach Anspruch 9,
wobei die Diagnoseeinheit (120) konfiguriert ist zum:
Bestimmen eines Simulationselektrodenprofils mit einem minimalen Fehler mit dem Zielelektrodenprofil unter den ersten bis m-ten Simulationselektrodenprofilen, und
Bestimmen von ersten bis n-ten Anpassungskoeffizienten eines beliebigen der ersten bis m-ten Anpassungskoeffizientensätze, die in dem Vorgang des Erzeugens des bestimmten Simulationselektrodenprofils verwendet werden, als die ersten bis n-ten Gewichtungsfaktoren.

11. Diagnosevorrichtung (100) nach Anspruch 1,
wobei die Profilerfassungseinheit (110) konfiguriert ist, um das Zielelektrodenprofil basierend auf einem Mess-Vollzellenprofil zu erhalten, das eine Kapazität-Spannung-Beziehung der Batterie (11) darstellt.

12. Batterieherstellungssystem, umfassend die Diagnosevorrichtung (100) nach einem der Ansprüche 1 bis 11.

13. Batteriepack (10), umfassend die Diagnosevorrichtung (100) nach einem der Ansprüche 1 bis 11.

14. Elektrofahrzeug, umfassend die Diagnosevorrichtung (100) nach einem der Ansprüche 1 bis 11.

15. Diagnoseverfahren, das von einer Diagnosevorrichtung (100) zum Diagnostizieren von Zuständen von ersten bis n-ten aktiven Materialien durchgeführt wird, die in einer Elektrode für eine Batterie (11) enthalten sind, wobei die Elektrode entweder eine positive Elektrode oder eine negative Elektrode ist, wobei das Diagnoseverfahren umfasst:
Erhalten eines Zielelektrodenprofils basierend auf Kapazität-Spannung-Messinformationen der Elektrode;
**gekennzeichnet durch**
Erzeugen von ersten bis m-ten Simulationselektrodenprofilen aus ersten bis n-ten Referenzprofilen für aktive Materialien; und
individuelles Vergleichen der ersten bis m-ten Simulationselektrodenprofile mit dem Zielelektrodenprofil, um die Zustände der ersten bis n-ten aktiven Materialien zu diagnostizieren,
wobei n eine natürliche Zahl von 2 oder mehr ist und m eine natürliche Zahl von 2 oder mehr ist.

## Revendications

1. Appareil de diagnostic (100) pour diagnostiquer des états d'un premier à des n^{ièmes} matériaux actifs inclus dans une électrode pour batterie (11), l'électrode est soit une électrode positive, soit une électrode négative, l'appareil de diagnostic (100) comprenant :
une unité d'obtention de profil (110) configurée pour obtenir un profil d'électrode cible représentant la relation correspondante entre la capacité et la tension de l'électrode ; et **caractérisé par**
une unité de diagnostic (120) configurée pour générer un premier à des m^{ièmes} profils d'électrode de simulation sur la base d'un premier à des n^{ièmes} profils de matériau actif de référence prédéterminés, pour comparer individuellement le premier aux m^{ièmes} profils d'électrode de simulation au profil d'électrode cible et pour diagnostiquer les états du premier aux n^{ièmes} matériaux actifs sur la base des résultats comparatifs,
dans lequel n est un nombre naturel de 2 ou plus, et m est un nombre naturel de 2 ou plus.

2. Appareil de diagnostic (100) selon la revendication 1,
dans lequel l'unité de diagnostic (120) est configurée pour :
déterminer le premier aux n^{ièmes} facteurs de pondération sur la base des résultats de comparaison individuels du premier aux m^{ièmes} profils d'électrode de simulation au profil d'électrode cible, et
déterminer une valeur caractéristique d'un k^{ième} matériau actif inclus dans l'électrode sur la base d'un k^{ième} facteur de pondération associé au k^{ième} matériau actif parmi le premier aux n^{ième} matériaux actifs,
dans lequel k est un nombre naturel inférieur ou égal à n,
dans lequel la valeur caractéristique indique une capacité actuellement disponible, un rapport de composition à l'intérieur de l'électrode, ou un poids.

3. Appareil de diagnostic (100) selon la revendication 2,
dans lequel l'unité de diagnostic (120) est configurée pour calculer la capacité actuellement disponible du k^{ième} matériau actif en multipliant le k^{ième} facteur de pondération par une k^{ième} capacité d'électrode de référence préréglée.

4. Appareil de diagnostic (100) selon la revendication 2,
dans lequel l'unité de diagnostic (120) est configurée pour calculer le rapport de composition à l'intérieur de l'électrode du k^{ième} matériau actif en divisant le k^{ième} facteur de pondération par la somme de tous, du premier aux n^{ième} facteurs de pondération.

5. Appareil de diagnostic (100) selon la revendication 2,
dans lequel l'unité de diagnostic (120) est configurée pour calculer le poids du k^{ième} matériau actif en multipliant un k^{ième} poids de référence préréglé et le k^{ième} facteur de pondération.

6. Appareil de diagnostic (100) selon la revendication 2,
dans lequel l'unité de diagnostic (120) est configurée pour diagnostiquer l'état du k^{ième} matériau actif sur la base de la valeur caractéristique du k^{ième} matériau actif et d'une k^{ième} valeur de seuil préréglée.

7. Appareil de diagnostic (100) selon la revendication 1,
dans lequel parmi le premier aux n^{ièmes} profils de matériau actif de référence, un k^{ième} profil de matériau actif de référence représente un rapport de capacité-tension obtenu dans un processus de charge ou décharge d'une k^{ième} électrode de référence, et
dans lequel la k^{ième} électrode de référence est fabriquée pour inclure un seul matériau actif qui est du même type de matériau actif que le k^{ième} matériau actif,
et k est un nombre naturel inférieur ou égal à n.

8. Appareil de diagnostic (100) selon la revendication 2,
dans lequel l'unité de diagnostic (120) est configurée pour générer le premier aux m^{ièmes} profils d'électrode de simulation en répétant une procédure d'ajustement et une procédure de synthèse pour le premier aux n^{ièmes} profils de matériau actif de référence en fonction d'un premier à des m^{ièmes} ensembles de coefficients d'ajustement.

9. Appareil de diagnostic (100) selon la revendication 8,
dans lequel l'unité de diagnostic (120) est configurée pour :
en tant que procédure d'ajustement, générer un premier à des n^{ièmes} profils de matériau actif d'ajustement associés à un j^{ième} ensemble de coefficients d'ajustement à partir du premier aux n^{ièmes} profils de matériau actif de référence en utilisant individuellement un premier à des n^{ièmes} coefficients d'ajustement du j^{ième} ensemble de coefficients d'ajustement parmi le premier aux m^{ièmes} ensembles de coefficients d'ajustement, et
en tant que procédure de synthèse, générer un j^{ième} profil d'électrode de simulation en synthétisant le premier aux n^{ièmes} profils de matériau actif d'ajustement associés au j^{ième} ensemble de coefficients d'ajustement,
dans lequel parmi le premier aux n^{ième} profils de matériau actif d'ajustement, le k^{ième} profil de matériau actif d'ajustement est obtenu en faisant évoluer un k^{ième} profil de matériau actif de référence par un k^{ième} coefficient d'ajustement le long d'un axe de capacité,
et j est un nombre naturel inférieur ou égal à m.

10. Appareil de diagnostic (100) selon la revendication 9,
dans lequel l'unité de diagnostic (120) est configurée pour :
déterminer un profil d'électrode de simulation ayant une erreur minimum avec le profil d'électrode cible parmi le premier aux m^{ième} profils d'électrode de simulation, et
déterminer le premier aux n^{ième} coefficients d'ajustement d'un quelconque du premier aux m^{ièmes} ensembles de coefficients d'ajustement, utilisés dans la procédure de génération du profil d'électrode de simulation déterminé, étant le premier aux n^{ième} facteurs de pondération.

11. Appareil de diagnostic (100) selon la revendication 1,
dans lequel l'unité d'obtention de profil (110) est configurée pour obtenir le profil d'électrode cible sur la base d'un profil de cellule complète de mesure représentant un rapport de capacité-tension de la batterie (11).

12. Système de fabrication de batterie, comprenant l'appareil de diagnostic (100) selon l'une quelconque des revendications 1 à 11.

13. Bloc batterie (10), comprenant l'appareil de diagnostic (100) selon l'une quelconque des revendications 1 à 11.

14. Véhicule électrique, comprenant l'appareil de diagnostic (100) selon l'une quelconque des revendications 1 à 11.

15. Procédé de diagnostic effectué par un appareil de diagnostic (100) pour diagnostiquer des états d'un premier à des n^{ièmes} matériaux actifs inclus dans une électrode pour batterie (11), dans lequel l'électrode est soit une électrode positive, soit une électrode négative, le procédé de diagnostic consistant à :
obtenir un profil d'électrode cible sur la base d'informations de mesure de capacite-tension de l'électrode ;
**caractérisé par** le fait de
générer un premier à des m^{ièmes} profils d'électrode de simulation à partir d'un premier à des n^{ièmes} profils de matériau actif de référence ; et
comparer individuellement le premier aux m^{ièmes} profils d'électrode de simulation avec le profil d'électrode cible pour diagnostiquer les états du premier aux n^{ièmes} matériaux actifs,
dans lequel n est un nombre naturel de 2 ou plus, et m est un nombre naturel de 2 ou plus.
